# EUROPEAN PATENT APPLICATION

(11) **EP 4 848 939 A1**
(43) Date of publication of application: **02.12.2026**
(21) Application number: 26169577.9
(22) Date of filing: 31.03.2026
(51) Int. Cl.: H10D 62/10, H10D 30/66, H10D 64/23, H10D 64/27, H10D 12/00, H10D 30/01, H10D 62/832

(54) **METAL-OXIDE-SEMICONDUCTOR FIELD-EFFECT TRANSISTOR POWER SEMICONDUCTOR DEVICES INCLUDING GATE ELECTRODES**

(30) Priority: 30.05.2025 KR 20250071170
(71) Applicant: Samsung Electronics Co., Ltd., Suwon-si, Gyeonggi-do 16677 (KR)
(72) Inventor: KIM, Taehun, 16677 Suwon-si, Gyeonggi-do (KR); PARK, Jeonghwan, 16677 Suwon-si, Gyeonggi-do (KR); SHIN, Dongmyung, 16677 Suwon-si, Gyeonggi-do (KR); PARK, Younghwan, 16677 Suwon-si, Gyeonggi-do (KR); MOON, Jeongje, 16677 Suwon-si, Gyeonggi-do (KR); KIM, Dongho, 16677 Suwon-si, Gyeonggi-do (KR)
(74) Representative: Kuhnen & Wacker Patent- und Rechtsanwaltsbüro PartG mbB

(57) **Abstract**

A power semiconductor device includes , a drift layer (103) on a substrate (101), gate electrodes (130) on the drift layer (103), spaced apart from each other in a first direction (X), a dielectric layer (142) at least partially covering the drift layer (103) and the gate electrodes (130), a first well region (105) disposed in a lower region between the gate electrodes (130), a first gate bus line (155) on the dielectric layer (142), first gate contact plugs at least partially penetrating the dielectric layer (142) and respectively coupling the first gate bus line (155) with the gate electrodes (130), and being spaced apart from each other in the first direction (X), a first source electrode (150a) on the dielectric layer (142) and spaced apart from the first gate bus line (155) in the second direction (Y), a second source electrode on the dielectric layer (142) and spaced apart from the first source electrode (150a) in the second direction (Y), and a drain electrode (180) on a lower surface of the substrate (101).

## Description

### BACKGROUND

### 1. Field

The present disclosure relates generally to power semiconductor devices, and more particularly, to metal-oxide-semiconductor field-effect transistor (MOSFET) power semiconductor devices.

### 2. Description of Related Art

Power semiconductor devices may refer to semiconductor devices that may operate in relatively high-voltage and/or relatively high-current environments, and may be used in fields that may require high-power switching, such as, but not limited to, power conversion, power converters, or inverters. Power semiconductor devices may need to withstand and/or perform in relatively high-voltage environments, as well as, may need to perform relatively high-speed switching operations. Accordingly, power semiconductor devices using silicon carbide (SiC), which may provide superior characteristics in such environments, when compared to silicon (Si), may be being researched.

### SUMMARY

One or more example embodiments of the present disclosure provide power semiconductor devices with improved electrical characteristics, when compared to related power semiconductor devices.

According to an aspect of the present disclosure, a power semiconductor device includes a substrate having a first conductivity type, a drift layer on the substrate and having the first conductivity type, gate electrodes on the drift layer, spaced apart from each other in a first direction, and extending in a second direction, a dielectric layer at least partially covering the drift layer and the gate electrodes, a first well region having a second conductivity type, being disposed in a lower region between the gate electrodes within the drift layer, and extending in the second direction, a first gate bus line on the dielectric layer and extending in the first direction, first gate contact plugs at least partially penetrating the dielectric layer and respectively coupling the first gate bus line with the gate electrodes, and being spaced apart from each other in the first direction, a first source electrode on the dielectric layer and spaced apart from the first gate bus line in the second direction, a second source electrode on the dielectric layer and spaced apart from the first source electrode in the second direction, with the first gate bus line being interposed therebetween, and a drain electrode on a lower surface of the substrate. The second direction intersects the first direction.

According to an aspect of the present disclosure, a power semiconductor device includes a substrate having a first conductivity type, gate electrodes on the substrate, spaced apart from each other in a first direction, and extending in a second direction, a dielectric layer at least partially covering the gate electrodes, a gate bus line on the dielectric layer and extending in the first direction, a first source electrode on the dielectric layer and spaced apart from the gate bus line in the second direction, a second source electrode on the dielectric layer and spaced apart from the first source electrode in the second direction with the gate bus line interposed therebetween, gate contact plugs at least partially penetrating the dielectric layer, at least partially overlapping the gate bus line and the gate electrodes in a vertical direction, respectively coupling the gate bus line with the gate electrodes, and being spaced apart from each other in the first direction, and a drain electrode on a lower surface of the substrate. The second direction intersects the first direction.

According to an aspect of the present disclosure, a power semiconductor device includes a substrate having a first conductivity type, a drift layer on the substrate and having the first conductivity type, a well region within the drift layer, having a second conductivity type, and extending in a first direction from an upper surface of the drift layer, a source region within the well region, having the first conductivity type, and extending from an upper surface of the well region, gate electrodes on the drift layer, extending in the first direction, and being spaced apart from each other in a second direction, a dielectric layer at least partially covering the drift layer and the gate electrodes, a first source electrode and a second source electrode on the dielectric layer and spaced apart from each other in the first direction, a gate bus line on the dielectric layer and extending in the second direction, between the first source electrode and the second source electrode, gate contact plugs at least partially penetrating the dielectric layer and respectively coupling the gate bus line with the gate electrodes, and being spaced apart in the second direction, source contact plugs at least partially penetrating the dielectric layer and coupling the first source electrode and the second source electrode with the source region, and a drain electrode on a lower surface of the substrate. The second direction intersects the first direction.

Additional aspects may be set forth in part in the description which follows and, in part, may be apparent from the description, and/or may be learned by practice of the presented embodiments.

### BRIEF DESCRIPTION OF DRAWINGS

The above and other aspects, features, and advantages of certain embodiments of the present disclosure may be more apparent from the following description taken in conjunction with the accompanying drawings, in which:
FIGS. 1A and 1B are schematic plan views of some components of a power semiconductor device, according to example embodiments;
FIG. 2 is a cross-sectional view illustrating an example embodiment of the power semiconductor device of FIGS. 1A and 1B taken along line I-I';
FIG. 3 is a cross-sectional view illustrating an example embodiment of the power semiconductor device of FIGS. 1A and 1B taken along line II-II';
FIG. 4A is a cross-sectional view illustrating an example embodiment of the power semiconductor device of FIGS. 1A and 1B taken along line III-III';
FIGS. 4B and 4C are cross-sectional views illustrating other example embodiments of the power semiconductor device of FIGS. 1A and 1B taken along line III-III';
FIG. 5 is a cross-sectional view illustrating an example embodiment of the power semiconductor device of FIGS. 1A and 1B taken along line IV-IV';
FIG. 6 is a cross-sectional view illustrating an example embodiment of the power semiconductor device of FIGS. 1A and 1B taken along line I-I';
FIG. 7 is a cross-sectional view illustrating an example embodiment of the power semiconductor device of FIGS. 1A and 1B taken along line II-II';
FIG. 8 is a cross-sectional view illustrating an example embodiment of the power semiconductor device of FIGS. 1A and 1B taken along line III-III';
FIGS. 9 to 11 are schematic plan views of some components of a power semiconductor device, according to example embodiments; and
FIGS. 12A, 12B, 13A, and 13B are drawings illustrating a process sequence for illustrating a method of manufacturing a power semiconductor device, according to an example embodiment.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be exemplary only. Therefore, those of ordinary skill in the art may recognize that various changes and modifications of the embodiments described herein may be made without departing from the scope and spirit of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", or the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", or the like may be used to distinguish components from each other and do not limit the present disclosure. For example, the terms "first", "second", "third", or the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

As used herein, each of the terms "Al₂O₃", "CoSi", "GaAs", "GaN", "HfAlₓO_{y}", "HfO₂", "HfSiₓO_{y}", "InAs", "InP", "LaAlₓO_{y}", "LaHfₓO_{y}", "La₂O₃", "LaSi", "MoSi", "NiSi", "Pr₂O₃", "SiC", "SiGe", "Si₃N₄", "SiO₂", "SiOₓN_{y}", "TaN", "Ta₂O₃", "TaSi", "TiN", "TiO₂", "TiSi", "WN", "WSi", "Y₂O₃", "ZrO₂", "ZrSiₓO_{y}", or the like may refer to a material made of elements included in each of the terms and is not a chemical formula representing a stoichiometric relationship.

Hereinafter, various embodiments of the present disclosure are described with reference to the accompanying drawings.

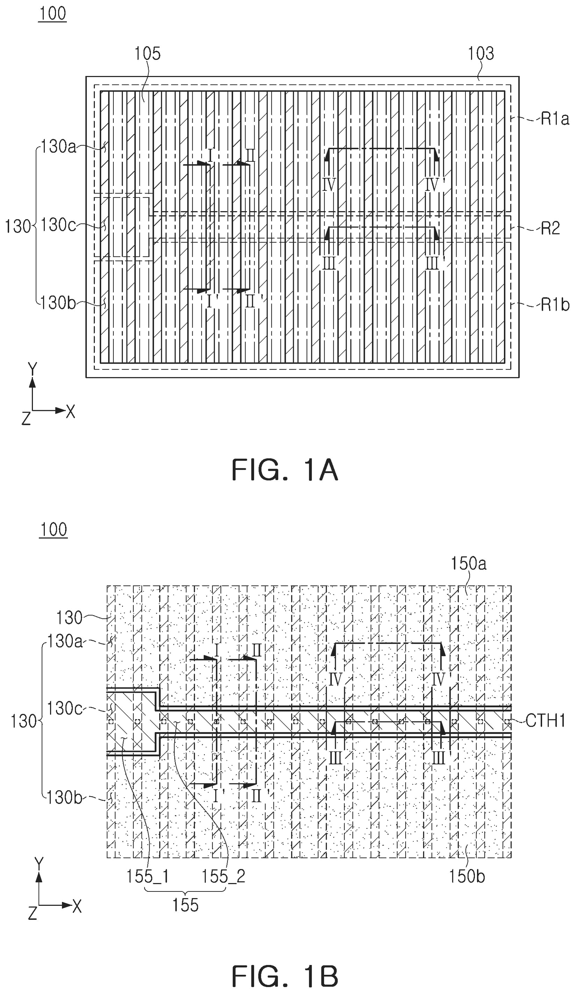

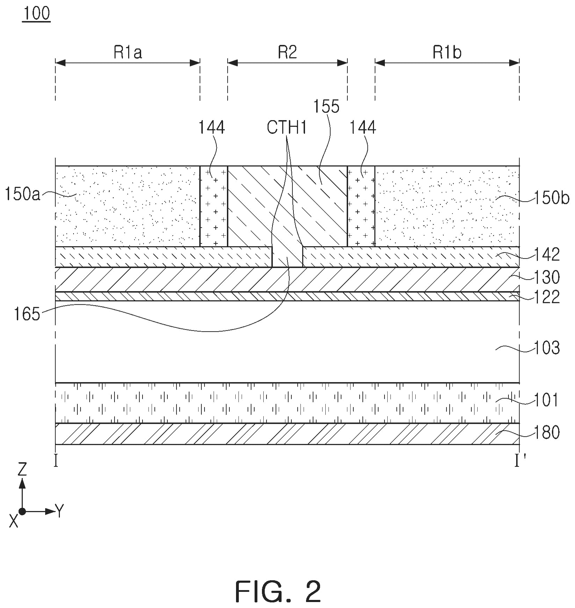

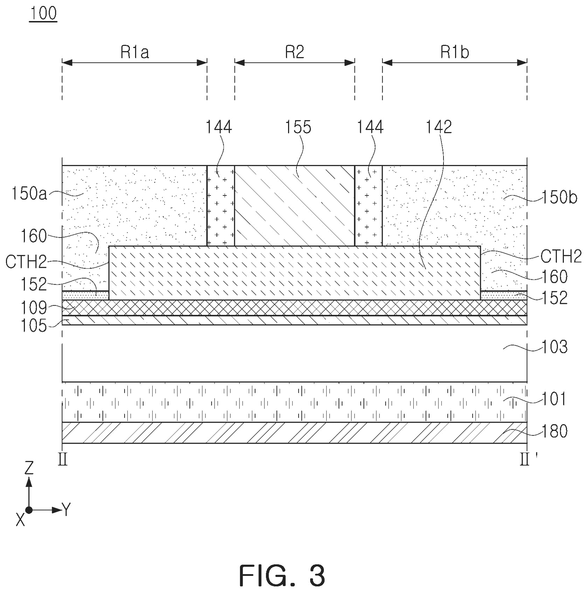

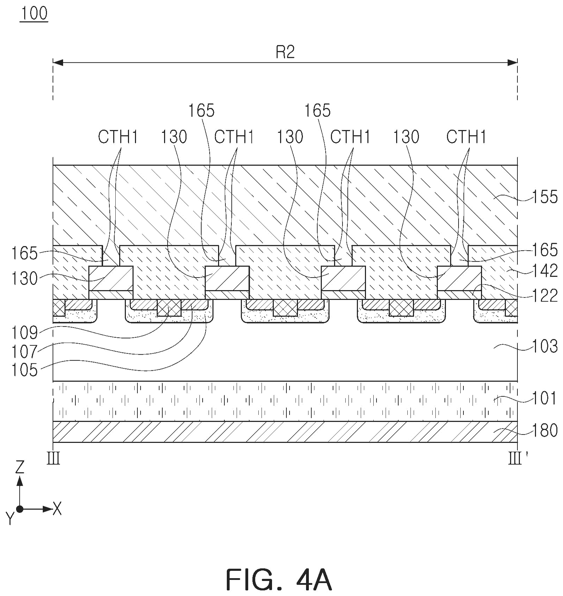

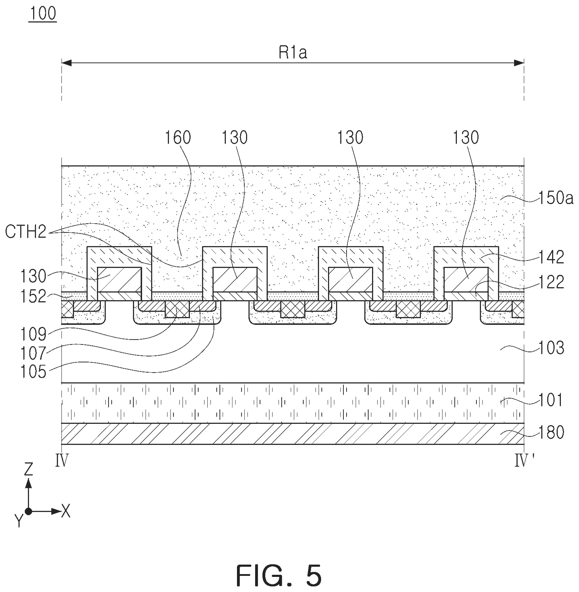

FIGS. 1A and 1B are schematic plan views of some components of a power semiconductor device, according to example embodiments. FIG. 2 is a cross-sectional view illustrating an example embodiment of the power semiconductor device of FIGS. 1A and 1B taken along line I-I'. FIG. 3 is a cross-sectional view illustrating an example embodiment of the power semiconductor device of FIGS. 1A and 1B taken along line II-II'. FIG. 4A is a cross-sectional view illustrating an example embodiment of the power semiconductor device of FIGS. 1A and 1B taken along line III-III'. FIG. 5 is a cross-sectional view illustrating an example embodiment of the power semiconductor device of FIGS. 1A and 1B taken along line IV-IV'.

FIG. 1A is a schematic plan view of a drift layer 103, well regions 105 on a drift layer 103, and gate electrodes 130 on the drift layer 103 of a power semiconductor device 100, according to an example embodiment. FIG. 1B is a schematic plan view of a gate bus line 155, a first source electrode 150a, and a second source electrode 150b of a power semiconductor device 100, according to an example embodiment.

Referring to FIGS. 1A, 1B, 2, 3, 4A, and 5, the power semiconductor device 100 may include a drift layer 103 on a substrate 101, well regions 105 extending from an upper surface of the drift layer 103 and spaced apart from each other in a first direction (X-direction), a source region 107 extending from an upper surface of each of the well regions 105, a well contact region 109 on one side of the source region 107, gate electrodes 130 on the drift layer 103, a gate insulating layer 122 between the gate electrodes 130 and the drift layer 103, a dielectric layer 142 covering the gate electrodes 130 and the drift layer 103, first and second source electrodes 150a and 150b disposing on the dielectric layer 142, a gate bus line 155 extending in a first direction (X-direction) between the first and second source electrodes 150a and 150b, on the dielectric layer 142, an insulating pattern 144 disposed between the first and second source electrodes 150a and 150b and the gate bus line 155, and a drain electrode 180 on the lower surface of the substrate 101.

The substrate 101 may have an upper surface extending in the first direction (X-direction) and the second direction (Y-direction). The substrate 101 may include a semiconductor material, for example, silicon carbide (SiC). However, in some embodiments, the substrate 101 may include a group IV semiconductor material such as, but not limited to, silicon (Si) or germanium (Ge), or a compound semiconductor material such as, but not limited to, gallium nitride (GaN), silicon-germanium (SiGe), gallium arsenide (GaAs), indium arsenide (InAs), indium phosphide (InP), or the like.

The substrate 101 may be provided as a bulk wafer and/or an epitaxial layer. The substrate 101 may include first conductivity type impurities, and thus, may have a first conductivity type. In some embodiments, the first conductivity type may be, for example, N-type, and the first conductivity type impurities may be, for example, N-type impurities such as, but not limited to, nitrogen (N) and/or phosphorus (P). In an embodiment, the first conductivity type may be, for example, P-type impurities. Hereinafter, unless otherwise specified, the description may be made based on the case where the power semiconductor device 100 includes an N-type metal-oxide-semiconductor field-effect transistor (MOSFET). However, embodiments of the present disclosure are not limited thereto, and the power semiconductor device 100 may include a P-type MOSFET.

The substrate 101 may include a first cell region R1a, a second cell region R1b spaced apart from the first cell region R1a in a second direction (Y-direction), and a dummy region R2 between the first cell region R1a and the second cell region R1b. The first cell region R1a may be a region that overlaps with the first source electrode 150a in a vertical direction (Z-direction), the second cell region R1b may be a region that overlaps with the second source electrode 150b in a vertical direction (Z-direction). The dummy region R2 may be a region that overlaps with the gate bus line 155 in a vertical direction (Z-direction).

The drift layer 103 may be disposed on the substrate 101. The drift layer 103 may include a semiconductor material. The drift layer 103 may be and/or may include an epitaxial layer grown on the substrate 101. The drift layer 103 may include first conductivity type impurities, and thus may have the first conductivity type. The concentration of the first conductivity type impurities of the drift layer 103 may be lower than the concentration of the first conductivity type impurities of the substrate 101. In example embodiments, the first conductivity type impurities in the substrate 101 and the drift layer 103 may be substantially similar and/or the same. Alternatively, the conductivity type impurities in the substrate 101 and the drift layer 103 may be different from each other.

The well regions 105 may be disposed at a predetermined depth from the upper surface of the drift layer 103 and may be disposed spaced apart from each other in the first direction (X-direction). The well regions 105 may overlap the first and second cell regions R1a and R1b and the dummy region R2 in the vertical direction (Z-direction), and each of the well regions 105 may extend in the second direction (Y-direction). The well region 105 may include a semiconductor material, for example, silicon carbide (SiC). The well region 105 may be a region having a second conductivity type and may include second conductivity type impurities. The second conductivity type may be, for example, P-type, and the second conductivity type impurities may be, for example, P-type impurities such as, but not limited to, aluminum (Al). In some embodiments, the well region 105 may include a plurality of regions having different doping concentrations.

The source regions 107 may be disposed in the respective well regions 105, and may be disposed at a predetermined depth from the upper surface of the well region 105. The source region 107 may overlap the first and second cell regions R1a and R1b and the dummy region R2 in the vertical direction (Z-direction) and may extend in the second direction (Y-direction) within the well region 105. For example, the thickness of the source region 107 in the vertical direction (Z-direction) may be smaller than the thickness of the well region 105. The source region 107 may include a semiconductor material, for example, may include silicon carbide (SiC). The source region 107 may have a concentration of first conductivity type impurities higher than the concentration of first conductivity type impurities of the drift layer 103. However, embodiments of the present disclosure are not limited thereto.

The well contact regions 109 may be disposed on the well regions 105 on at least some of the source regions 107 and one side thereof. For example, the well contact region 109 may be disposed at a predetermined depth from the upper surface of the well region 105. The well contact region 109 may overlap the first and second cell regions R1a and R1b and the dummy region R2 in the vertical direction (Z-direction). However, embodiments of the present disclosure are not limited thereto. In an embodiment, the well contact region 109 may overlap the first and second cell regions R1a and R1b in the vertical direction (Z-direction), and may not overlap the dummy region R2 in the vertical direction (Z-direction).

The well contact region 109 may allow voltage to be applied from the first and second source electrodes 150a and 150b to the well region 105 between the well region 105 and the first and second source electrodes 150a and 150b. For example, the relative depth of the well contact region 109 and the source region 107 may be variously changed. The well contact region 109 may include a semiconductor material, for example, silicon carbide (SiC). The well contact region 109 may be a region having the second conductivity type, and may include second conductivity type impurities substantially similar and/or the same as the second conductivity type impurities described above. The concentration of the second conductivity type impurities in the well contact region 109 may be higher than the concentration of the second conductivity type impurities in the well region 105.

The gate electrodes 130 may be disposed on the gate insulating layer 122 on the drift layer 103 and may extend in the second direction (Y-direction) and be spaced apart in the first direction (X-direction). The gate electrodes 130 may respectively overlap the first and second cell regions R1a and R1b and the dummy region R2 in the vertical direction (Z-direction). Each of the gate electrodes 130 may be disposed on the upper region between the well regions 105. The gate electrodes 130 may extend in the second direction (Y-direction) on the gate insulating layer 122. Each of the gate electrodes 130 may be disposed on the upper region between the well regions 105 and may overlap the outer region of each of the well regions 105 in the vertical direction (Z-direction). Each of the gate electrodes 130 may include overlapping portions that may overlap the upper surface of the well regions 105 in the vertical direction (Z-direction) and may extend in the second direction (Y-direction), and a non-overlapping portion that may be provided between the overlapping portions, may overlap with the drift layer 103 exposed between the well regions 105 in the vertical direction (Z-direction) and may extend in the second direction (Y-direction).

The well region 105 may include first regions that may be disposed in a lower region between gate electrodes 130 spaced apart from each other in a first direction (X direction), may overlap the gate electrodes 130, and may be spaced apart from each other in the first direction (X-direction), and a second region that may be disposed between the first regions and may not overlap the gate electrodes 130.

Each of the gate electrodes 130 may be in the form of a gate liner extending in the second direction (Y-direction). For example, each of the gate electrodes 130 may include a first gate portion 130a that may overlap the first cell region R1a in the vertical direction (Z-direction), a gate contact portion 130c extending from the first gate portion 130a and that may overlap the dummy region R2 in the vertical direction (Z-direction), and a second gate portion 130b extending from the gate contact portion 130c and that may overlap the second cell region R1b in the vertical direction (Z-direction). In an embodiment, the length of each of the first gate portion 130a and the second gate portion 130b in the second direction (Y-direction) may be longer than the length of the gate contact portion 130c in the second direction (Y-direction). For example, the length of the first gate portion 130a in the second direction (Y-direction) may be substantially similar and/or the same as the length of the second gate portion 130b in the second direction (Y-direction).

In an embodiment, a lower surface of the first gate portion 130a, a lower surface of the second gate portion 130b, and a lower surface of the gate contact portion 130c may be in contact with an upper surface of the gate insulating layer 122. For example, an upper surface of the first gate portion 130a, an upper surface of the second gate portion 130b, and an upper surface of the gate contact portion 130c may be disposed at a substantially similar and/or the same vertical level.

As used herein, the gate contact portion 130c may be referred to as the first portion, the first gate portion 130a may be referred to as the second portion, and the second gate portion 130b may be referred to as the third portion.

The gate electrode 130 may include a conductive material, for example, a semiconductor material such as, but not limited to, doped polycrystalline silicon, a metal nitride such as, but not limited to, titanium nitride (TiN), a tantalum nitride film (TaN), or a tungsten nitride film (WN), and/or a metal material such as, but not limited to, aluminum (Al), tungsten (W), or molybdenum (Mo). According to example embodiments, the gate electrode 130 may be composed of two (2) or more multilayers.

The gate insulating layer 122 may be disposed on a lower surfaces of the gate electrodes 130, and a lower surface of the gate insulating layer 122 may be in contact with a portion of the upper surface of the well region 105, a portion of the upper surface of the source region 107, and an upper surface of the drift layer 103.

The gate insulating layer 122 may include an insulating material. For example, the gate insulating layer 122 may include an oxide, a nitride, or a high-κ material. The high-κ material may refer to a dielectric material having a higher dielectric constant than a silicon oxide film (SiO₂). The high-κ material may include at least one of, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), praseodymium oxide (Pr₂O₃), or the like.

The dielectric layer 142 may cover the gate electrodes 130 and the drift layer 103. The dielectric layer 142 may be in contact with the upper surface and side surfaces of the gate electrodes 130, the side surfaces of the gate insulating layer 122, the upper surface of the source region 107, and the upper surface of the well contact region 109. The dielectric layer 142 may include an insulating material, and may include, but not be limited to, at least one of silicon oxide (SiO₂), silicon nitride (Si₃N₄), silicon oxynitride (SiOₓN_{y}), or the like.

The gate bus line 155 and the first and second source electrodes 150a and 150b may be disposed on the dielectric layer 142.

The gate bus line 155 may overlap the dummy region R2 in the vertical direction (Z-direction) on the dielectric layer 142. The gate bus line 155 may be disposed between the first source electrode 150a and the second source electrode 150b, on the dielectric layer 142, and extend in the first direction (X-direction).

The gate bus line 155 may include a first gate bus line portion 155_1 having a first width in the second direction (Y-direction) and a second gate bus line portion 155_2 extending from the first gate bus line portion 155_1 and having a second width smaller than the first width in the second direction (Y-direction). The first gate bus line portion 155_1 may be and/or may include an area where a conductive terminal is disposed, and/or may be and/or may include a gate pad area of the gate electrodes 130. The gate bus line 155 may be and/or may include a gate interconnection structure for connecting the gate electrodes 130 externally. The conductive terminal may be and/or may include a gate wire and/or a wire pad to which the gate wire may be connected.

The first and second source electrodes 150a and 150b may be disposed on the dielectric layer 142 and/or may be electrically connected to the source regions 107 and the well contact regions 109. The first source electrode 150a may be disposed on the dielectric layer 142 covering the first gate portion 130a. The first source electrode 150a may be disposed on the dielectric layer 142 covering the first gate portion 130a and may overlap the first cell region R1a in the vertical direction (Z-direction). The second source electrode 150b may be disposed on the dielectric layer 142 covering the second gate portion 130b and may overlap the second cell region R1b in the vertical direction (Z-direction). The second source electrode 150b may be spaced apart from the first source electrode 150a in the second direction (Y-direction).

The first and second source electrodes 150a and 150b may include a metal material, for example, at least one of nickel (Ni), aluminum (Al), titanium (Ti), silver (Ag), vanadium (V), tungsten (W), cobalt (Co), molybdenum (Mo), copper (Cu), ruthenium (Ru), or the like.

The first source electrode 150a, the gate bus line 155, and the second source electrode 150b may be disposed side by side on the dielectric layer 142 in the second direction (Y-direction). Insulating patterns 144 may be disposed between the first and second source electrodes 150a and 150b and the gate bus line 155. For example, the insulating patterns 144 may fill the space between the first and second source electrodes 150a and 150b and the gate bus line 155. The insulating patterns 144 may insulate the first and second source electrodes 150a and 150b and the gate bus line 155.

The power semiconductor device 100 may further include gate contact holes CTH1 penetrating the dielectric layer 142 and connecting the gate bus line 155 and the gate electrodes 130, gate contact plugs 165 filling the gate contact holes CTH1, source contact holes CTH2 penetrating the dielectric layer 142 and the gate insulating layer 122 and connecting the first and second source electrodes 150a and 150b and the well contact regions 109, and source contact plugs 160 filling the source contact holes CTH2.

The gate contact holes CTH1 may overlap the dummy region R2 in the vertical direction (Z-direction) and may be spaced apart in the first direction (X-direction). The gate contact holes CTH1 may penetrate the dielectric layer 142 and expose upper surfaces of the respective gate electrodes 130. Each of the gate contact plugs 165 may fill each of the gate contact holes CTH1. For example, the gate contact plugs 165 may overlap the dummy region R2 in the vertical direction (Z-direction) and may be spaced apart in the first direction (X-direction). The gate contact plugs 165 may respectively penetrate the dielectric layer 142 and connect the respective gate electrodes 130 and the gate bus line 155. For example, the gate contact plugs 165 may have a pillar shape.

The gate bus line 155 may be disposed on the gate contact plugs 165 and connected to the gate electrodes 130 through the gate contact plugs 165.

The width of each of the gate contact plugs 165 in the first direction (X-direction) may be smaller than the spacing between the well regions 105 spaced apart in the first direction (X-direction). The gate contact plugs 165 may not respectively overlap the well regions 105 in the vertical direction (Z-direction). The gate contact plugs 165 may respectively overlap, in the vertical direction (Z-direction), the upper surface of the drift layer 103 exposed between the well regions 105 spaced apart from each other in the first direction (X-direction). However, embodiments of the present disclosure are not limited thereto, and respective portions of the gate contact plugs 165 may overlap the well regions 105 in the vertical direction (Z-direction), and a remaining portion of each of the gate contact plugs 165 may overlap the upper surface of the drift layer 103 exposed between the well regions 105 in the vertical direction (Z-direction).

The source contact holes CTH2 may overlap the first and second cell regions R1a and R1b in the vertical direction (Z-direction), and may be spaced apart in the first direction (X-direction) and the second direction (Y-direction). The source contact holes CTH2 disposed in the first cell region R1a may be spaced apart in the first direction (X-direction). The source contact hole CTH2 may penetrate the dielectric layer 142 and expose an upper surface of the metal-semiconductor compound layer 152. The source contact plugs 160 may respectively fill the source contact holes CTH2. For example, the source contact hole CTH2 may have a line shape extending in the second direction (Y-direction). However, embodiments of the present disclosure are not limited thereto, and the source contact hole CTH2 may have a pillar shape. The source contact plugs 160 may penetrate the dielectric layer 142 and contact the metal-semiconductor compound layer 152 to connect the first and second source electrodes 150a and 150b and the well contact region 109. For example, the source contact plugs 160 may have a line shape extending in the second direction (Y-direction). However, embodiments of the present disclosure are not limited thereto, and the source contact plug 160 may have a pillar shape.

The first and second source electrodes 150a and 150b may be disposed on respective source contact plugs 160. As used herein, the source contact plug 160 connecting the first source electrode 150a and the well contact region 109 may be referred to as a first source contact plug, and the source contact plug 160 connecting the second source electrode 150b and the well contact region 109 may be referred to as a second source contact plug.

The gate contact plug 165 and the source contact plug 160 may include a conductive plug. The conductive plug may include a metal material, for example, tungsten (W), titanium (Ti), aluminum (Al), copper (Cu), or the like.

The power semiconductor device 100 may further include a metal-semiconductor compound layer 152 disposed at an interface where the source contact plugs 160 and the source region 107 come into contact. The metal-semiconductor compound layer 152 may include a metal element and/or a semiconductor element, and may include at least one of titanium silicide (TiSi), cobalt silicide (CoSi), molybdenum silicide (MoSi), lanthanum silicide (LaSi), nickel silicide (NiSi), tantalum silicide (TaSi), tungsten silicide (WSi), or the like.

The drain electrode 180 may be disposed on a lower surface of the substrate 101 and may be electrically connected to the substrate 101. The drain electrode 180 may include a metal material, for example, at least one of nickel (Ni), aluminum (Al), titanium (Ti), silver (Ag), vanadium (V), tungsten (W), or the like.

The power semiconductor device 100, according to example embodiments, may include gate electrodes 130 that are disposed across first and second cell regions R1a and R1b and a dummy region R2 and are spaced apart in a first direction (X-direction) and extend in a second direction (Y-direction), a gate bus line 155 that may overlap the dummy region R2 in a vertical direction (Z-direction), on the gate electrodes 130, and extends in the first direction (X-direction), and gate contact plugs 165 that connect the gate bus line 155 and the gate electrodes 130. The well region 105 may not be disposed below the gate contact plugs 165, and the shape of the gate contact portion 130c of the gate electrodes 130 disposed in the dummy region R2 may be substantially similar to and/or the same as the shape of the first and second gate portions 130a and 130b of the gate electrodes 130 disposed in the first and second cell regions R1a and R1b.

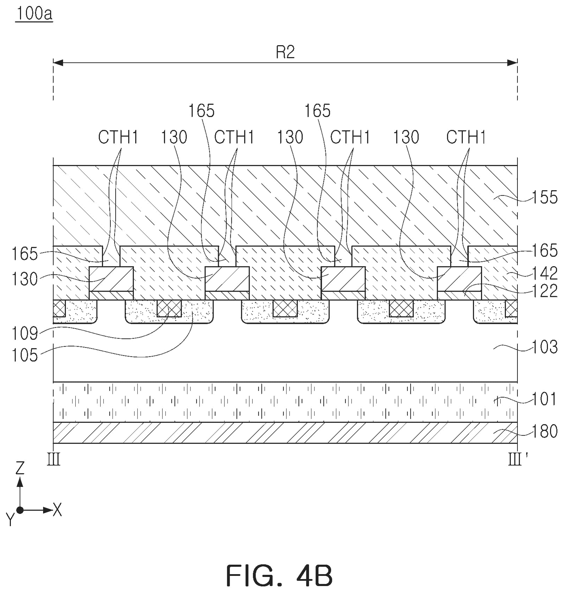

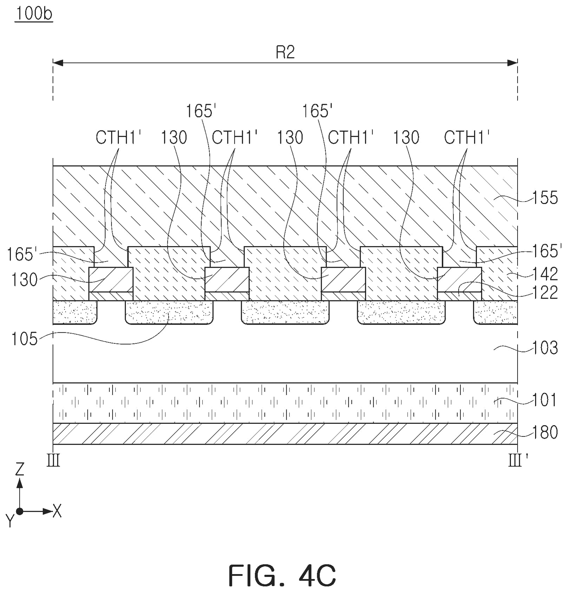

FIGS. 4B and 4C are cross-sectional views illustrating various embodiments taken along line III - III' of the power semiconductor device of FIGS. 1A and 1B.

Referring to FIGS. 4B and 5, a power semiconductor device 100a may include well regions 105 spaced apart from each other in a first direction (X-direction) and extending in a second direction (Y-direction) within the drift layer 103, a source region 107 extending from respective upper surfaces of the well regions 105 and extending in a second direction (Y-direction), within the well regions 105 that overlap the first and second cell regions R1a and R1b in a vertical direction (Z-direction), and a well contact region 109 extending in a second direction (Y-direction) from an upper surface of the well region 105 within the well regions 105 that overlap the dummy region R2 in a vertical direction (Z-direction). The source region 107 may not be formed within the dummy region R2. For example, the source region 107 may be partially formed only within the well region 105 overlapping the first and second cell regions R1a and R1b. The well contact regions 109 overlapping the dummy region R2 may be in contact with the well regions 105.

Referring to FIGS. 4C and 5, a power semiconductor device 100b may include gate contact holes CTH1' penetrating the dielectric layer 142 and connecting the gate bus line 155 and the gate electrodes 130, and gate contact plugs 165' filling the gate contact holes CTH1'. The gate contact plugs 165' may respectively overlap portions of the well regions 105 spaced apart from each other in the first direction (X-direction), in the vertical direction (Z-direction). For example, the width of each of the gate contact plugs 165' in the first direction (X-direction) may be greater than the spacing distance between the well regions 105 spaced apart from each other in the first direction (X-direction).

A lower surface of each of the first gate contact plugs 165' may include first contact portions including one side surface overlapping the well regions 105 in the vertical direction (Z-direction) and the other side surface facing the one side surface, and a second contact portion that is disposed between the first contact portions and does not overlap the well region 105 in the vertical direction (Z-direction).

The power semiconductor device 100b may include well regions 105 spaced apart from each other in a first direction (X-direction) and extending in a second direction (Y-direction) within the drift layer 103, a source region 107 extending from an upper surface of each of the well regions 105 and extending in a second direction (Y-direction) within the well regions 105 that overlap the first and second cell regions R1a and R1b in a vertical direction (Z-direction), and a well contact region 109 extending in the second direction (Y-direction) from the upper surface of the source region 107. The source region 107 and the well contact region 109 may not be formed within the dummy region R2. For example, the source region 107 and the well contact region 109 may be partially formed only within the well region 105 that overlaps the first and second cell regions R1a and R1b.

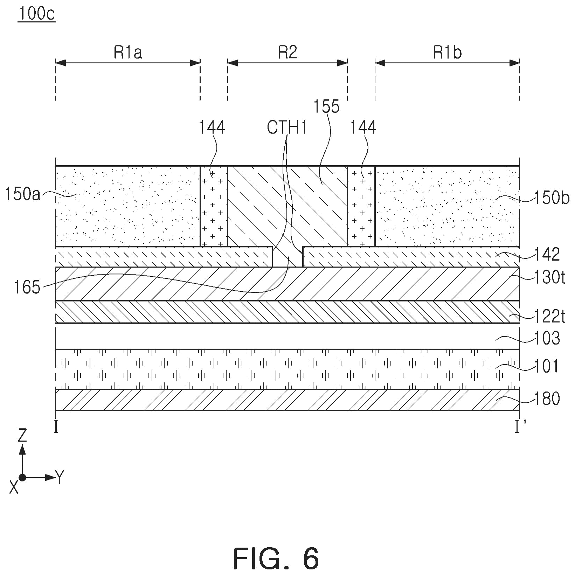

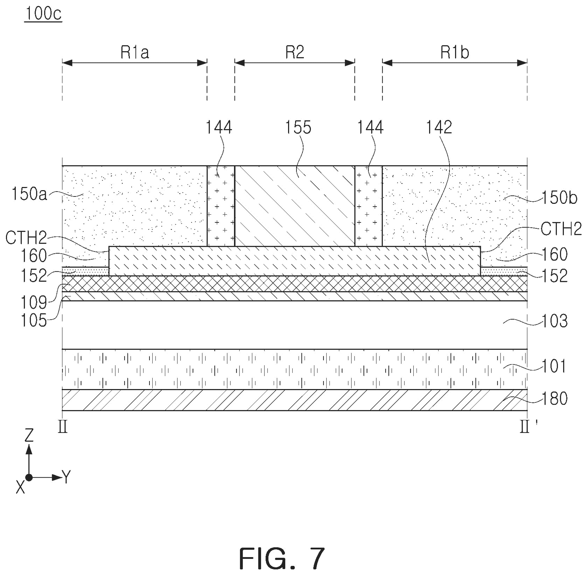

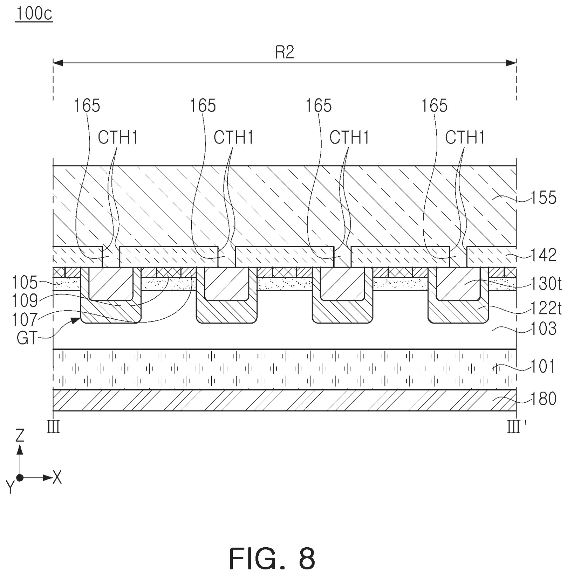

FIG. 6 is a cross-sectional view illustrating an example embodiment of the power semiconductor device of FIGS. 1A and 1B, taken along line I - I '. FIG. 7 is a cross-sectional view illustrating an example embodiment of the power semiconductor device of FIGS. 1A and 1B, taken along line II - II'. FIG. 8 is a cross-sectional view illustrating an example embodiment of the power semiconductor device of FIGS. 1A and 1B, taken along line III - III'.

Referring to FIGS. 6, 7, and 8, the remaining configurations of a power semiconductor device 100c except for a gate electrode 130t and a gate insulating film 122t in a gate trench GT may include and/or may be similar in many respects to the configurations illustrated in FIGS. 2, 3, and 4A, and may include additional features not mentioned above. Consequently, repeated descriptions of the power semiconductor device 100c described above with reference to FIGS. 2, 3, and 4A may be omitted for the sake of brevity.

The gate trench GT may extend into the drift layer 103 by penetrating through the source regions 107 and the well regions 105 from the upper surfaces of the source regions 107. The gate trench GT may completely penetrate the well region 105, and the lower end of the gate trench GT may be located within the drift layer 103. However, the length of the gate trench GT extended into the drift layer 103 may vary according to various embodiments.

The gate trench GT may include a sidewall extending in the third direction (Z-direction) and contacting the source regions 107, the well regions 105, and the drift layer 103, and a bottom surface that may extend from the sidewall and contacts the drift layer 103. In an embodiment, a gate trench GT may include sidewalls contacting the source regions 107 and the well regions 105 and a bottom surface extending from the sidewalls to contact the well region 105.

The gate trench GT may have an angular shape without a curve. The angle between the sidewall and the bottom surface of the gate trench GT may be a right angle. For example, the sidewall of the gate trench GT may have a side surface extending vertically, and the width of the gate trench GT may be substantially constant. However, embodiments of the present disclosure are not limited thereto. As another example, the angle between the sidewall and the bottom surface of the gate trench GT may be an obtuse angle. In such an example, the sidewall of the gate trench GT may have an inclined side surface. The width of the gate trench GT may become smaller toward the bottom of the gate trench GT. For example, the bottom surface of the gate trench GT may be substantially extended in a straight line in the first direction (X-direction). However, embodiments of the present disclosure are not limited thereto, and the shape of the gate trench GT may be variously modified.

The gate electrodes 130t may be respectively disposed within the gate trench GT. The gate electrode 130t may be disposed on the gate insulating film 122t within the gate trench GT. For example, the gate electrode 130t may overlap the gate insulating film 122t, the drift layer 103, the well region 105, and the source region 107 in the horizontal direction. The lower surface of the gate electrode 130t may be located within the drift layer 103. The lower surface of the gate electrode 130t may be positioned at a level lower than the lower surface of the well region 105, and the upper surface of the gate electrode 130t may be disposed at a substantially similar and/or the same level as the upper surface of the source region 107. However, embodiments of the present disclosure are not limited thereto, and the upper surface of the gate electrode 130t may be positioned at a level lower than the upper surface of the source region 107.

The gate electrode 130t may include a side surface having a shape corresponding to the side wall of the gate trench GT, an upper surface extending from the side surface and contacting the dielectric layer 142, and a lower surface contacting the gate insulating film 122t.

The gate insulating film 122t may be disposed within the gate trench GT. The gate insulating film 122t may cover the side surface and the lower surface of the gate electrode 130t. For example, a gate insulating film 122t may be disposed between a source region 107, a well contact region 109, a well region 105, a drift layer 103, and a gate electrode 130t. The gate insulating film 122t may include an insulating material. The insulating material may include, for example, an oxide or a nitride. The gate insulating film 122t may be composed of a plurality of insulating layer films.

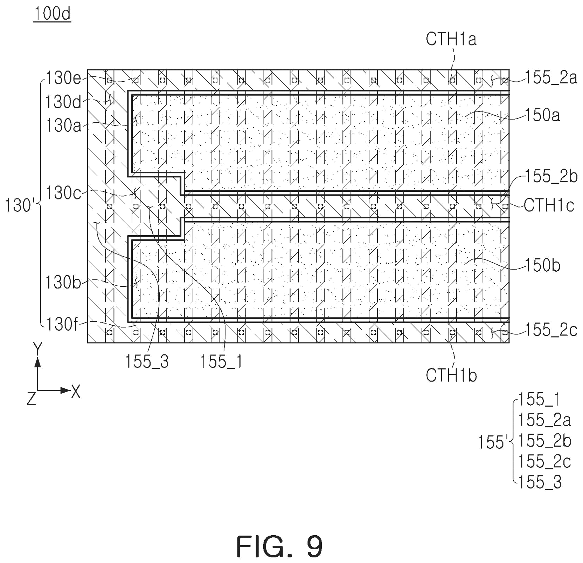

FIGS. 9 to 11 are schematic plan views of some components of a power semiconductor device, according to various embodiments.

Referring to FIG. 9, a power semiconductor device 100d may include gate electrodes 130' spaced apart from each other in a first direction (X-direction) and extending in a second direction (Y-direction), first and second source electrodes 150a and 150b disposed on the gate electrodes 130', and a gate bus line 155' disposed on the gate electrodes 130' and spaced apart from the first and second source electrodes 150a and 150b. The remaining components except for the gate electrodes 130' and the gate bus line 155' may include and/or may be similar in many respects to the components illustrated in FIGS. 2, 3, and 4A, and may include additional features not mentioned above. Consequently, repeated descriptions of the remaining components described above with reference to FIGS. 2, 3, and 4A may be omitted for the sake of brevity.

The gate bus line 155' may include a gate bus body portion 155_3 extending in a second direction (Y-direction), a first gate bus line 155_2a extending from the gate bus body portion 155_3 in a first direction (X-direction), a gate bus pad portion 155_1 extending from the gate bus body portion 155_3 in a first direction (X-direction), a second gate bus line 155_2b extending from the gate bus pad portion 155_1 in a first direction (X-direction), and a third gate bus line 155_2c extending from the gate bus body portion 155_3 in a first direction (X-direction). For example, the first to third gate bus lines 155_2a to 155_2c may be spaced apart from each other in the second direction (Y-direction).

The gate bus pad portion 155_1 of the gate bus line 155' of FIG. 9 may correspond to the first gate bus line portion 155_1 of the gate bus line 155 of FIG. 2.

The first source electrode 150a may be disposed between the first gate bus line 155_2a and the gate bus pad portion 155_1 and between the first gate bus line 155_2a and the second gate bus line 155_2b when viewed in a plane. The second source electrode 150b may be disposed between the gate bus pad portion 155_1 and the third gate bus line 155_2c and between the second gate bus line 155_2b and the third gate bus line 155_2c when viewed in a plane view. For example, the insulating pattern 144 of FIG. 2 may be disposed between the gate bus line 155' and the first and second source electrodes 150a and 150b.

The gate electrodes 130' may include a dummy gate electrode 130d overlapping with the gate bus body portion 155_3, and gate electrode portions 130a, 130b, 130c, 130e, and 130f overlapping with the first and second source electrodes 150a and 150b, the gate pad portion 155_1, and the first to third gate bus lines 155_2a to 155_2c. Each of the gate electrode portions 130a, 130b, 130c, 130e, and 130f may include a first gate portion 130a overlapping the first source electrode 150a, a second gate portion 130b overlapping the second source electrode 150b, a dummy gate electrode 130d overlapping with the gate bus body portion 155_3, a first gate contact portion 130e overlapping the first gate bus line 155_2a, a second gate contact portion 130c overlapping the gate pad portion 155_1 and the second gate bus line 155_2b, and a third gate contact portion 130f overlapping the third gate bus line 155_2c.

The power semiconductor device 100d may include first gate contact holes CTH1a connecting the first gate bus line 155_2a and the gate electrodes 130, third gate contact holes CTH1c connecting the gate bus pad portion 155_1 of the gate bus line 155' and the second gate bus line 155_2b and the gate electrodes 130, and second gate contact holes CTH1b connecting the third gate bus line 155_2c and the gate electrodes 130. For example, the first gate contact holes CTH1a may overlap the first gate contact portions 130e in the vertical direction (Z-direction), the second gate contact holes CTH1b may overlap the third gate contact portions 130f in the vertical direction (Z-direction), and the third gate contact holes CTH1c may overlap the second gate contact portions 130c in the vertical direction (Z-direction). For example, the first gate contact holes CTH1a, the second gate contact holes CTH1b, and the third gate contact holes CTH1c may respectively penetrate the dielectric layer 142 of FIG. 2 to connect the gate bus line 155' and the gate electrodes 130', respectively, and may be spaced apart from each other in the first direction (X-direction).

The power semiconductor device 100d may further include dummy gate contact holes that vertically overlap the dummy gate electrodes 130d of the gate electrodes 130' and connect the gate electrodes 130' and the gate bus line 155'.

In an embodiment, the power semiconductor device 100d may include only third gate contact holes CTH1c excluding the first and second gate contact holes CT1a and CTH1b of the power semiconductor device 100d to connect the gate electrodes 130' and the gate bus line 155'.

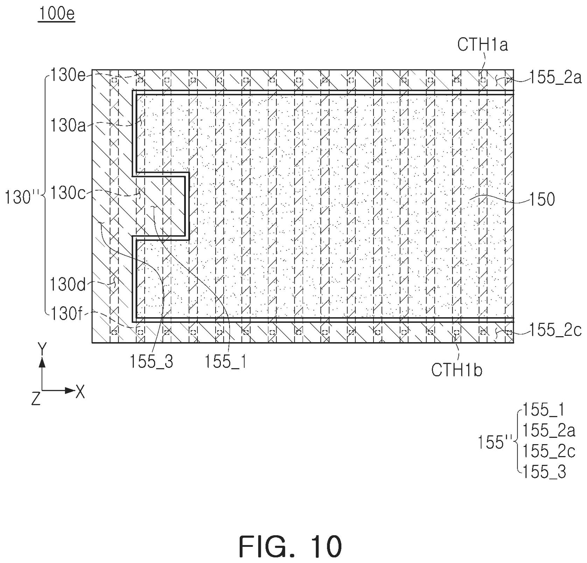

Referring to FIG. 10, a power semiconductor device 100e may include a source electrode 150, a gate electrode 130", and a gate bus line 155". The remaining configurations except for the source electrode 150, the gate electrodes 130", and the gate bus line 155" may include and/or may be similar in many respects to the configurations illustrated in FIGS. 2, 3, and 4A, and may include additional features not mentioned above. Consequently, repeated descriptions of the remaining configurations described above with reference to FIGS. 2, 3, and 4A may be omitted for the sake of brevity.

The gate bus line 155" may include a gate bus body portion 155_3 extending in a second direction (Y-direction), a first gate bus line 155_2a extending from the gate bus body portion 155_3 in a first direction (X-direction), a gate bus pad portion 155_1 extending from the gate bus body portion 155_3 in a first direction (X-direction), and a third gate bus line 155_2c extending from the gate bus body portion 155_3 in a first direction (X-direction). The first gate bus line 155_2a and the third gate bus line 155_2c may be spaced apart from each other in a second direction (Y-direction).

The source electrode 150 may be disposed between the first gate bus line 155_2a and the third gate bus line 155_2c, and may protrude between the first gate bus line 155_2a and the gate bus pad portion 155_1, and between the third gate bus line 155_2c and the gate bus pad portion 1155_1, while being disposed between the first gate bus line 155_2a and the third gate bus line 155_2c. One side of the source electrode 150 may be surrounded by the gate bus body portion 155_3, the first gate bus line 155_2a, and the third gate bus line 155_2c.

The gate electrodes 130" may include a dummy gate electrode 130d overlapping the gate bus body portion 155_3, and gate electrode portions 130a, 130c, 130e, and 130f overlapping the gate pad portion 155_1 and the first and third gate bus lines 155_2a and 155_2c. Each of the gate electrode portions 130a, 130c, 130e, and 130f may include a first gate portion 130a overlapping the source electrode 150, a first gate contact portion 130e overlapping the first gate bus line 155_2a, a second gate contact portion 130c overlapping the gate pad portion 155_1, and a third gate contact portion 130f overlapping the third gate bus line 155_2c.

The power semiconductor device 100e may include first gate contact holes CTH1a connecting the first gate bus line 155_2a and the gate electrodes 130" and second gate contact holes CTH1b connecting the third gate bus line 155_2c and the gate electrodes 130".

For example, the first gate contact holes CTH1a and the second gate contact holes CTH1b may respectively penetrate the dielectric layer 142 of FIG. 2 to connect the gate bus line 155" and the gate electrodes 130", and may be spaced apart from each other in the first direction (X-direction).

The first gate contact portion 130e may overlap each of the first gate contact holes CTH1a, and the third gate contact portion 130c may overlap each of the second gate contact holes CTH1b.

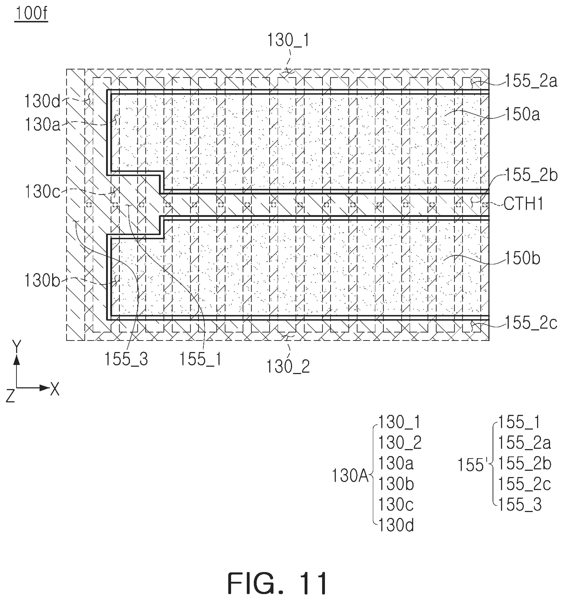

Referring to FIG. 11, a power semiconductor device 100f may include gate electrodes 130A, first and second source electrodes 150a and 150b disposed on the gate electrodes 130A, and a gate bus line 155' disposed on the gate electrodes 130A and spaced apart from the first and second source electrodes 150a and 150b. The remaining configurations except for the gate electrodes 130A and the gate bus line 155' may include and/or may be similar in many respects to the configurations illustrated in FIGS. 2, 3, and 4A, and may include additional features not mentioned above. Furthermore, the gate bus line 155' of the power semiconductor device 100f may include and/or may be similar in many respects to the gate bus line 155' of the power semiconductor device 100d of FIG. 9, and may include additional features not mentioned above. Consequently, repeated descriptions of the remaining configurations described above with reference to FIGS. 2, 3, 4A, and 9 may be omitted for the sake of brevity.

The gate electrodes 130A may include a dummy gate electrode 130d overlapping the gate bus body portion 155_3, a first gate body portion 130_1 overlapping the first gate bus line 155_2a and extending in the first direction (X-direction), a second gate body portion 130_2 overlapping the third gate bus line 155_2c and extending in the first direction (X-direction), and gate electrode portions 130a, 130b and 130c overlapping the first and second source electrodes 150a and 150b, the gate pad portion 155_1 and the second gate bus line 155_2b.

The dummy gate electrode 130d and gate electrode portions 130a, 130b, and 130c may be disposed between the first and second gate body portions 130_1 and 130_2. The gate electrode portions 130a, 130b, and 130c may include a first gate portion 130a overlapping the first source electrode 150a, a second gate portion 130b overlapping the second source electrode 150b, and a second gate contact portion 130c overlapping the gate pad portion 155_1 and the second gate bus line 155_2b.

The dummy gate electrode 130d and the respective gate electrode portions 130a, 130b, and 130c may extend from the first and second gate body portions 130_1 and 130_2 and may extend in the second direction (Y-direction). The first and second gate body portions 130_1 and 130_2 may be spaced apart from each other in the second direction (Y-direction) and may extend in the first direction (X-direction).

The first gate body portion 130_1 may overlap the first gate bus line 155_2a in the vertical direction (Z-direction), and the second gate body portion 130_2 may overlap the third gate bus line 155_2c in the vertical direction (Z-direction). As used herein, the first gate body portion 130_1 may be referred to as a first gate pattern, and the second gate body portion 130_2 may be referred to as a second gate pattern.

The power semiconductor device 100f may include gate contact holes CTH1 connecting the gate bus pad portion 155_1 and the second gate bus line 155_2b with the gate electrodes 130A. For example, the gate contact holes CTH1 may respectively penetrate the dielectric layer 142 of FIG. 2 to connect the gate bus line 155' and the gate electrodes 130A, respectively, and may be spaced apart from each other in the first direction (X-direction). Each of the gate contact holes CTH1 may overlap the second gate contact portion 130c in the vertical direction.

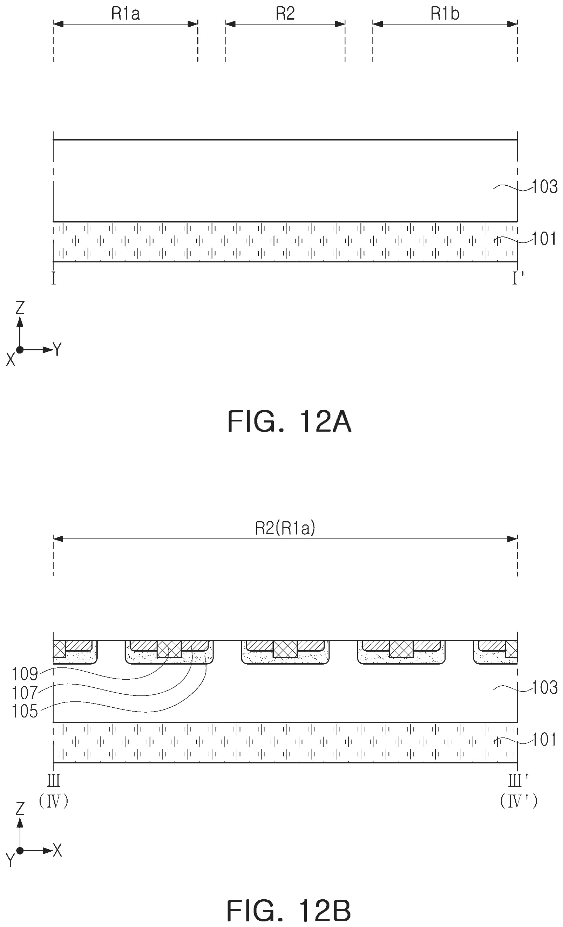

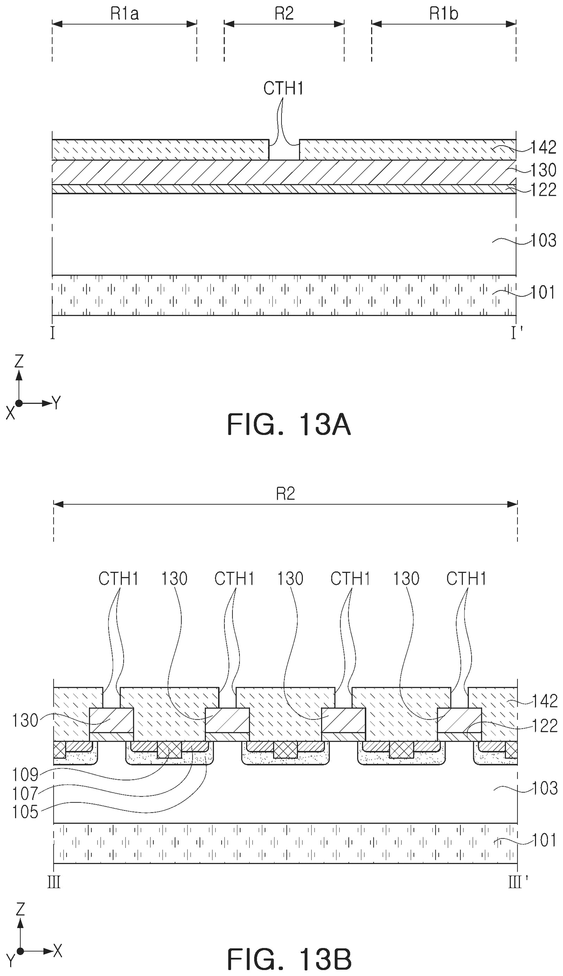

FIGS. 12A, 12B, 13A, and 13B are drawings illustrating a method of manufacturing a power semiconductor device, according to an example embodiment, in accordance with a process sequence.

Referring to FIGS. 1A, 1B, 12A, 12B, 13A, and 13B, a method of manufacturing a power semiconductor device, according to an example embodiment, may include an operation of forming a drift layer 103 of a first conductivity type on a substrate 101 including a first cell region R1a, a second cell region R1b spaced apart from the first cell region R1a in a second direction (Y-direction), and a dummy region R2 between the first cell region R1a and the second cell region R1b, an operation of forming well regions 105 of a second conductivity type extending in the second direction (Y-direction) and spaced apart from each other in a first direction (X-direction) intersecting the second direction (Y-direction) within the drift layer 103 (refer to FIGS. 12A and 12B), an operation of forming gate electrodes 130 extending in the second direction (Y-direction) and spaced apart from each other in the first direction (X-direction) on the drift layer 103 between the well regions 105, an operation of forming a dielectric layer 142 on the drift layer 103 and the gate electrodes 130, an operation of forming gate contact holes CTH1 penetrating the dielectric layer 142, overlapping the dummy region R2 in the vertical direction (Z-direction), and spaced apart from each other in the first direction (X-direction) (see FIGS. 13A and 13B), an operation of forming a first source electrode 150a on the dielectric layer 142 overlapping the first cell region R1a in the vertical direction (Z-direction) and forming a second source electrode 150b on the dielectric layer 142 overlapping the second cell region R1b in the vertical direction (Z-direction), and an operation of forming a gate bus line 155 that overlaps the dummy region R2 in the vertical direction (Z-direction) and extends in the first direction (X-direction) on the dielectric layer 142 (see FIG. 1B).

Referring to FIGS. 12A and 12B, the drift layer 103 may be formed on a substrate 101, and a well region 105, a source region 107, and well contact regions 109 may be sequentially formed.

The substrate 101 may be provided as, for example, a silicon carbide (SiC) wafer. The drift layer 103 may be formed by epitaxial growth from the substrate 101. The drift layer 103 may be formed to include first conductivity type impurities. The substrate 101 may include a first cell region R1a in which the first source electrode 150a of FIG. 1B is formed, a second cell region R1b in which the second source electrode 150b of FIG. 1B is formed, and a dummy region R2 in which the gate bus line 155 of FIG. 1B is formed.

The well region 105, the source region 107, and the well contact region 109 may be sequentially formed in the drift layer 103 by an ion implantation process. Second conductivity type impurities may be implanted into the well region 105 and the well contact region 109, and first conductivity type impurities may be implanted into the source region 107. After the ion implantation process, an annealing process may be performed at a high temperature, for example, at a temperature of about 1600°C to about 1800°C. However, embodiments of the present disclosure are not limited thereto.

The well regions 105 may be formed to be spaced apart from each other in a first direction (X-direction) and extend in a second direction (Y-direction) across the first and second cell regions R1a and R1b and the dummy region R2. The source region 107 and the well contact region 109 may be respectively formed to be spaced apart from each other in a first direction (X-direction) and extend in a second direction (Y-direction) in a substantially similar and/or the same manner as the arrangement of the well regions 105 within the well regions 105. For example, in an area between well regions 105 spaced apart from each other in the first direction (X-direction), which is an area corresponding to FIG. 12A, a well region 105 is not formed, and the upper surface of the drift layer 103 may be exposed. However, embodiments of the present disclosure are not limited thereto. In an embodiment, the source region 107 is formed within each of the well regions 105 that overlap the first and second cell regions R1a and R1b and the dummy region R2 in the vertical direction (Z-direction), and the well contact region 109 may be formed to penetrate at least a portion of the source region 107 only within the well region 105 that overlaps the first and second cell regions R1a and R1b. For example, the well contact region 109 may not be formed within the well region 105 that overlaps the dummy region R2. In an embodiment, the source region 107 and the well contact region 109 may be sequentially formed only within the well region 105 that overlaps the first and second cell regions R1a and R1b. For example, the source region 107 and the well contact region 109 may not be formed within the well region 105 overlapping the dummy region R2.

Referring to FIGS. 13A and 13B, a gate insulating layer 122, gate electrodes 130, and a dielectric layer 142 may be formed.

The gate insulating layer 122 may be formed on the drift layer 103. The gate insulating layer 122 may be formed by first forming a uniform first insulating layer by an oxidation process, for example, a thermal oxidation process, and then further forming a second insulating layer on the first insulating layer by a spin-on glass (SOG) process and/or a high temperature oxide (HTO) process.

The gate electrodes 130 may be formed on the gate insulating layer 122. The gate electrodes 130 may be spaced apart from each other in the first direction (X-direction) and may extend in the second direction (Y-direction) between the well regions 105. The source region 107 and the well contact region 109 may be exposed between the gate electrodes 130 spaced apart from each other in the first direction (X-direction). The gate electrodes 130 may be formed, for example, by depositing doped polycrystalline silicon.

A dielectric layer 142 covering the source regions 107, the well contact region 109, and the gate electrodes 130 may be formed.

The dielectric layer 142 may be deposited over the entire upper surface of the structure being manufactured, and then gate contact holes CTH1 penetrating the dielectric layer 142 may be formed by an etching process to expose the upper surfaces of the respective gate electrodes 130 overlapping the dummy region R2. Source contact holes (CHT2 in FIG. 3) penetrating the dielectric layer 142 may also be formed to expose a portion of the well contact region 109 overlapping the first and second cell regions R1a and R1b. The dielectric layer 142 may be formed to cover the upper surface and side surface of the gate electrode 130, the side surface of the gate insulating layer 122, the upper surface of the source region 107, and the upper surface of the well contact region 109.

Referring to FIGS. 1B, 2, 3, and 4A together, gate contact plugs 165 filling gate contact holes CTH1, source contact plugs 160 filling source contact holes CTH2, first and second source electrodes 150a and 150b, and gate bus line 155 may be formed, and a drain electrode 180 may be formed on the lower surface of the substrate 101.

Metal-semiconductor compound layers 152 may be formed at the interface of well contact regions 109 exposed through source contact holes CTH2, source contact plugs 160 may be formed to fill the source contact holes CTH2 and cover the metal-semiconductor compound layers 152, and gate contact plugs 165 may be formed to fill the gate contact holes CTH1. The source contact plugs 160 and the gate contact plugs 165 may be formed by a plating process, a physical vapor deposition (PVD) process, or a chemical vapor deposition (CVD) process.

First and second source electrodes 150a and 150b may be formed to cover the source contact plugs 160 and the dielectric layer 142, and the gate bus line 155 may be formed to cover the gate contact plugs 165 and the dielectric layer 142. A conductive terminal may be formed on the first gate bus line portion 155_1 of the gate bus line 155. As a result, the power semiconductor device 100 of FIGS. 1A and 1B may be manufactured.

According to example embodiments, a method of manufacturing a power semiconductor device includes forming a drift layer of a first conductivity type on a substrate including a first cell region, a second cell region spaced apart from the first cell region in a first direction, and a dummy region between the first cell region and the second cell region, forming well regions of a second conductivity type extending in the first direction and spaced apart in a second direction, intersecting the first direction, within the drift layer, forming gate electrodes extending in the first direction and spaced apart in the second direction, on the drift layer between the well regions, forming a dielectric layer on the drift layer and the gate electrodes, forming gate contact holes penetrating through the dielectric layer, overlapping the dummy region in a vertical direction, and spaced apart in the second direction, forming a first source electrode on the dielectric layer overlapping the first cell region in the vertical direction, and forming a second source electrode on the dielectric layer overlapping the second cell region in the vertical direction, and forming a gate bus line overlapping the dummy region in the vertical direction and extending on the dielectric layer in the second direction.

In an example embodiment, the gate contact holes may overlap the gate electrodes in the vertical direction, respectively.

In an example embodiment, the method of manufacturing the power semiconductor device may further include forming a source region of the first conductivity type extending in the first direction within the respective well regions that overlap the first cell region and the second cell region in the vertical direction.

In an example embodiment, the source region may not overlap the dummy region in the vertical direction.

In an example embodiment, the method of manufacturing the power semiconductor device may further include forming a well contact region of a second conductivity type penetrating the source region and extending in the first direction within each of the well regions.

In an example embodiment, the well contact region may overlap the dummy region in the vertical direction.

In an example embodiment, the method of manufacturing the power semiconductor device may further include forming a first source contact plug penetrating through the dielectric layer and overlapping with the first cell region in the vertical direction, and forming a second source contact plug penetrating through the dielectric layer and overlapping the second cell region in the vertical direction.

In an example embodiment, the respective gate contact holes may not overlap the respective well regions in the vertical direction.

In an example embodiment, the first and second source electrodes may be formed at a substantially similar and/or the same vertical level as the gate bus line.

In an example embodiment, the method of manufacturing the power semiconductor device may further include forming a conductive terminal on the gate bus line.

As set forth above, a power semiconductor device, according to example embodiments, may include gate electrodes spaced apart from each other in a first direction and extending in a second direction across a cell region and a dummy region on a drift layer, and gate contact plugs connecting a gate bus line overlapping the dummy region to the respective gate electrodes. Accordingly, as the gate electrodes of the dummy region have a substantially similar and/or the same arrangement as the gate electrodes disposed in the cell region, the source electrode overlapping the cell region and the gate bus line overlapping the dummy region, which are disposed on the dielectric layer, may be disposed at a substantially similar and/or the same vertical level, thereby maintaining planarization.

While example embodiments have been illustrated and described above, it may be apparent to those skilled in the art that modifications and variations may be made without departing from the scope of the present disclosure as defined by the appended claims.

## Claims

1. A power semiconductor device, comprising:
a substrate (101) having a first conductivity type;
a drift layer (103) on the substrate (101) and having the first conductivity type;
gate electrodes (130; 130'; 130"; 130t) on the drift layer (103), spaced apart from each other in a first direction (X), and extending in a second direction (Y), the second direction (Y) intersecting the first direction (X);
a dielectric layer (142) at least partially covering the drift layer (103) and the gate electrodes (130; 130'; 130"; 130t);
a first well region (105) having a second conductivity type, being disposed in a lower region between the gate electrodes (130; 130'; 130"; 130t) within the drift layer (103), and extending in the second direction (Y);
a first gate bus line (155; 155_1, 155_2b; 155_1) on the dielectric layer (142) and extending in the first direction (X);
first gate contact plugs (165; 165') at least partially penetrating the dielectric layer (142) and respectively coupling the first gate bus line (155; 155_1, 155_2b; 155_1) with the gate electrodes (130; 130'; 130"; 130t), and being spaced apart from each other in the first direction (X);
a first source electrode (150a) on the dielectric layer (142) and spaced apart from the first gate bus line (155; 155_1, 155_2b; 155_1) in the second direction (Y);
a second source electrode (150b) on the dielectric layer (142) and spaced apart from the first source electrode (150a) in the second direction (Y), with the first gate bus line (155; 155_1, 155_2b; 155_1) being interposed therebetween; and
a drain electrode (180) on a lower surface of the substrate (101).

2. The power semiconductor device of claim 1, wherein the first gate contact plugs (165) do not overlap the first well region (105) in a vertical direction (Z).

3. The power semiconductor device of claim 1, wherein a lower surface of each of the first gate contact plugs (165') comprises:
a first contact portion at least partially overlapping the first well region (105) in a vertical direction (Z); and
a second contact portion not overlapping the first well region (105) in the vertical direction (Z).

4. The power semiconductor device of any one of claims 1 to 3, wherein the first well region (105) comprises:
first regions vertically overlapping the gate electrodes (130; 130'; 130") and being spaced apart from each other in the first direction (X); and
a second region between the first regions, the second region not overlapping the gate electrodes (130; 130'; 130").

5. The power semiconductor device of any one of claims 1 to 4, further comprising:
a source region (107) in the first well region (105), having the first conductivity type, and extending from an upper surface of the first well region (105); and
a first source contact plug (160) between the gate electrodes (130; 130'; 130"; 130t), and coupling the first source electrode (150a) with the source region (107) by at least partially penetrating the dielectric layer (142).

6. The power semiconductor device of claim 5, wherein the source region (107) at least partially overlaps the first source electrode (150a) and the second source electrode (150b) in a vertical direction (Z), and
wherein the source region (107) does not overlap the first gate bus line (155; 155_1, 155_2b; 155_1) in the vertical direction (Z).

7. The power semiconductor device of any one of claims 1 to 6, further comprising:
a gate insulating layer (122) on the drift layer (103),
wherein lower surfaces of the gate electrodes (130; 130'; 130") contact an upper surface of the gate insulating layer (122).

8. The power semiconductor device of any one of claims 1 to 7, wherein the first gate bus line (155; 155_1, 155_2b) comprises:
a first gate bus line portion (155_1) having a first width in the second direction (Y), and
a second gate bus line portion (155_2; 155_2b) extending from the first gate bus line portion (155_1) and having a second width smaller than the first width in the second direction (Y).

9. The power semiconductor device of claim 8, further comprising:
a conductive terminal on the first gate bus line portion (155_1).

10. The power semiconductor device of any one of claims 1 to 9, wherein each of the gate electrodes (130; 130'; 130") comprises:
a first portion (130c) at least partially overlapping the first gate bus line (155; 155_1, 155_2b; 155_1) in a vertical direction (Z); and
a second portion (130a) at least partially overlapping the first source electrode (150a) in the vertical direction (Z), and
wherein the first portion (130c) and the second portion (130a) are disposed at a same vertical level.

11. The power semiconductor device of claim 10, further comprising:
a second gate bus line (155_2a) on the gate electrodes (130'; 130") and spaced apart from the first gate bus line (155_2b) in the second direction (Y), with the first source electrode (150a) interposed therebetween,
wherein each of the gate electrodes (130'; 130") further comprises a third portion (130e) at least partially overlapping the second gate bus line (155_2a) in the vertical direction (Z), and
wherein the third portion (130e) is disposed at the same vertical level as the first portion (130c) and the second portion (130a).

12. The power semiconductor device of claim 11, further comprising:
second gate contact plugs at least partially penetrating the dielectric layer (142), at least partially overlapping the second gate bus line (155_2a) in the vertical direction (Z), and respectively coupling the second gate bus line (155_2a) with the third portion (130e) of each of the gate electrodes (130'; 130").

13. The power semiconductor device of claim 12, wherein the second gate contact plugs do not overlap the first well region (105) in the vertical direction (Z).

14. The power semiconductor device of any one of claims 1 to 13, further comprising:
a second well region (105) having the second conductivity type, being disposed in the drift layer (103) in the lower region between the gate electrodes (130; 130'; 130"), and being spaced apart from the first well region (105) in the first direction (X); and
a gate insulating layer (122) on the drift layer (103),
wherein an upper surface of the drift layer (103) extending in the second direction (Y) and exposed between the first well region (105) and the second well region (105) contacts a lower surface of the gate insulating layer (122).

15. The power semiconductor device of any one of the claims 1 to 14, further comprising:
a first gate pattern (130_1) on the drift layer (103) and extending in the first direction (X); and
a second gate pattern (130_2) on the drift layer (103), extending in the first direction (X), and being spaced apart from the first gate pattern (130_1) in the second direction (Y),
wherein each of the gate electrodes (130a, 130b, 130c) extends from the first gate pattern (130_1) and the second gate pattern (130_2) in the second direction (Y), between the first gate pattern (130_1) and the second gate pattern (130_2), and
wherein the first gate pattern (130_1) and the second gate pattern (130_2) do not overlap the first gate contact plugs in a vertical direction (Z).
